Europäisches Patentamt

(19) European Patent Office

Office européen des brevets

(11) Veröffentlichungsnummer: **0 011 808**
**B1**

(12) **EUROPÄISCHE PATENTSCHRIFT**

(45) Veröffentlichungstag der Patentschrift:
20.01.82

(21) Anmeldenummer: 79104602.2

(22) Anmeldetag: 19.11.79

(51) Int. Cl.³: **H 01 L 37/02**

(54) **Pyroelektrisches Bauelement für die Messung der Intensität elektromagnetischer Strahlung, für die Temperaturmessung sowie für die thermoelektrische Stromerzeugung und Verwendung dieses Bauelements.**

(30) Priorität: 30.11.78 DE 2851883

(43) Veröffentlichungstag der Anmeldung:
11.06.80 Patentblatt 80/12

(45) Bekanntmachung des Hinweises auf die Patenterteilung:
20.01.82 Patentblatt 82/3

(84) Benannte Vertragsstaaten:
FR GB NL

(56) Entgegenhaltungen:
FR-A-2 290 042

(73) Patentinhaber: Haussühl, Siegfried, Prof. Dr.,
Blessemerstrasse 31, D-5042 Erftstadt-Lechenich (DE)
Patentinhaber: Liebertz, Josef, Prof. Dr., Kölner Weg 19,
D-5000 Köln 40 (DE)

(72) Erfinder: Haussühl, Siegfried, Prof. Dr.,
Blessemerstrasse 31, D-5042 Erftstadt-Lechenich (DE)
Erfinder: Liebertz, Josef, Prof. Dr., Kölner Weg 19,
D-5000 Köln 40 (DE)

(74) Vertreter: Mehl, Ernst, Dipl.-Ing., Postfach 22 01 76,
D-8000 München 22 (DE)

Pyroelektrisches Bauelement für die Messung der Intensität elektromagnetischer Strahlung, für die Temperaturmessung sowie für die thermoelektrische Stromerzeugung und Verwendung dieses Bauelements

Die vorliegende Patentanmeldung betrifft ein pyroelektrisches Bauelement zur Messung der Intensität elektromagnetischer Strahlung, zur Temperaturmessung sowie zur thermoelektrischen Stromerzeugung.

Es ist bekannt, Einkristalle aus Triglycinsulfat für pyroelektrische Detektoren heranzuziehen. Triglycinsulfat und seine Isotypen besitzen die grössten pyroelektrischen Koeffizienten aller bis heute näher untersuchten Substanzen. Jede Temperaturänderung, z.B. hervorgerufen durch die Absorption elektromagnetischer Wellen, bewirkt eine Änderung der Polarisation und damit eine Ladungserzeugung, die mittels eines Ladungsverstärkers unmittelbar gemessen werden kann, wenn die betreffenden Kristallflächen mit geeigneten Elektroden versehen sind. Mit derselben Anordnung lassen sich auch Temperaturen messen. Ein Aggregat dünner grossflächiger Kristallplatten kann als thermoelektrischer Generator, z.B. unter Ausnutzung der Tag-Nacht-Schwankungen der Temperatur herangezogen werden.

Einkristalle aus Triglycinsulfat haben die Eigenschaften, sich oberhalb 49°C in eine nicht pyroelektrische Modifikation (paraelektrische Phase) umzuwandeln, so dass das bekannte Material nur in einem beschränkten Temperaturbereich bis maximal 49°C eingesetzt werden kann. Ausserdem ist das Triglycinsulfat mechanisch sehr instabil, hat eine sehr geringe Eindruckhärte und weist eine starke Wasserlöslichkeit auf, was besondere Massnahmen zur Verhinderung der Oberflächenleitfähigkeit erforderlich macht.

Aus der deutschen Offenlegungsschrift Nr. 2422664 ist nun ein pyroelektrisches Bauelement der eingangs genannten Art bekannt, welches die unangenehmen Eigenschaften des Triglycinsulfats nicht aufweist und im wesentlichen aus einem Einkristall aus rhombischem Magnesiumbariumfluorid besteht.

Aus FR-A- Nr. 2290042 ist ein pyroelektrisches Bauelement aus Bleigermanat bekannt.

Durch die Erfindung soll ein anderes pyroelektrisches Bauelement vorgeschlagen werden, welches ebenfalls vorteilhafter arbeitet als das eingangs beschriebene Triglycinsulfat.

Die Erfindung ist durch ein pyroelektrisches Bauelement der eingangs genannten Art gekennzeichnet, welches aus einem Einkristall auf der Basis von rhombischen Lithiummetagermanat ($Li_2GeO_3$) besteht. Dabei liegt es im Rahmen des Erfindungsgedankens, dass mindestens ein Lithiumatom ganz oder teilweise durch ein Natriumatom und/oder mindestens ein Germaniumatom ganz oder teilweise durch ein Siliziumatom ersetzt ist. Es wurde nämlich gefunden, dass Einkristalle aus rhombischen Lithiummetagermanat einen ungewöhnlich grossen pyroelektrischen Effekt längs der Achse zweizähliger Symmetrie (pyroelektrische Achse) besitzen.

Gegenüber Magnesiumbariumfluorid, dessen effektive pyroelektrische Konstante durch Bildung von ferroelektrischen Domänen entgegengesetzter Polarität beeinträchtigt werden kann, besitzt $Li_2Geo_3$ eine stabile Polarität; es ist daher ersterem in der Langzeitstabilität überlegen.

Vorteilhafterweise kann der Einkristall mit Elektroden zur Abnahme der erzeugten Ladungen versehen werden. Weiterhin kann bei einer bevorzugten Ausführungsform der Erfindung die dem Strahleintritt zugewandte Oberfläche des Kristalls mit einem selektiven Filter für bestimmte Spektralbereiche der elektromagnetischen Strahlung versehen werden.

Ein solches pyroelektrisches Bauelement kann vorteilhafterweise mit einem oder mehreren weiteren pyroelektrischen Bauelementen, von dem eines oder mehrere mit Filter versehen sind, simultan betrieben werden, um aus der Differenz der Signale die spektrale Verteilung der Intensität elektromagnetischer Strahlungen messen zu können.

Das erfindungsgemässe pyroelektrische Bauelement eignet sich insbesondere zur Messung der Intensität elektromagnetischer Strahlung aller Frequenzbereiche, auch extrem kleiner Intensitäten, sowie zur Messung von Temperaturen. Darüber hinaus kann das pyroelektrische Bauelement für die Messung anderer als elektromagnetischer Energieströme verwendet werden, z.B. für Neutronen-, Elektronen- oder Alphateilchenströme.

Mit Vorteil kann das erfindungsgemässe Bauelement auch zur direkten Spektralanalyse verwendet werden.

Zur Temperaturmessung kann die am Bauelement entstehende temperaturabhängige Polarisation mit einem Ladungsmessgerät bestimmt werden, vorzugsweise auch für höhere Temperaturen als 49°C.

Schliesslich eignet sich das erfindungsgemässe Bauelement zum Aufbau von Aggregaten dünner Kristallscheiben zur Herstellung grossflächiger, thermoelektrischer Generatoren für die Stromerzeugung. Hierbei werden die metallisierten Flächen gleicher Polarität jeweils mit einer Elektrode verbunden.

Die Herstellung grosser Einkristalle aus rhombischen Lithiummetagermanat von hoher Kristallqualität kann durch Züchtung aus der Schmelze nach dem Czochralski-Verfahren problemlos durchgeführt werden.

Eine selektive Empfindlichkeit des pyroelektrischen Bauelements gegenüber Strahlung in bestimmten Spektralbereichen kann durch Aufbringen geeigneter Filter oder Filme mit bestimmten Absorptionseigenschaften erreicht werden.

## Patentansprüche

1. Pyroelektrisches Bauelement zur Messung der Intensität elektromagnetischer Strahlung, zur Temperaturmessung sowie zur thermoelektrischen Stromerzeugung, dadurch gekennzeichnet, dass das pyroelektrische Bauelement aus einem Einkristall auf der Basis von rhombischen Lithium-metagermanat ($Li_2GeO_3$) besteht.

2. Pyroelektrisches Bauelement nach Anspruch 1, dadurch gekennzeichnet, dass mindestens ein Lithiumatom ganz oder teilweise durch ein Natriumatom und/oder mindestens ein Germaniumatom ganz oder teilweise durch ein Siliziumatom ersetzt ist.

3. Pyroelektrisches Bauelement nach Anspruch 1 und 2, dadurch gekennzeichnet, dass der Einkristall mit Elektroden zur Abnahme der elektrischen Ladungen versehen ist.

4. Pyroelektrisches Bauelement nach Anspruch 3, dadurch gekennzeichnet, dass die dem Strahleneintritt zugewandte Oberfläche des Kristalls mit einem selektiven Filter für bestimmte Spektralbereiche der elektromagnetischen Strahlung versehen ist.

5. Pyroelektrisches Bauelement nach Anspruch 4, dadurch gekennzeichnet, dass es mit einem oder mehreren weiteren pyroelektrischen Bauelementen, von denen eines oder mehrere mit Filtern versehen sind, simultan betrieben wird, um aus der Differenz der Signale die spektrale Verteilung der Intensität elektromagnetischer Strahlungen messen zu können.

6. Verwendung des pyroelektrischen Bauelements nach Anspruch 3 zur Messung von Neutronen-, Elektronen-, oder Alphateilchenströmen.

7. Verwendung des pyroelektrischen Bauelements nach Anspruch 5 zur direkten Spektralanalyse.

8. Verwendung des pyroelektrischen Bauelements nach Anspruch 3 zur Temperaturmessung vorzugsweise auch für höhere Temperaturen als 49°C, wobei die am Bauelement entstehende temperaturabhängige Polarisation mit einem Ladungsmessgerät bestimmt wird.

9. Verwendung mehrerer pyroelektrischer Bauelemente nach Anspruch 3 Herstellung thermoelektrischer Generatoren für die Stromerzeugung, wobei die metallisierten Flächen gleicher Polarität der Bauelemente jeweils mit eindander verbunden sind.

## Claims

1. A pyro-electric component for measuring the intensity of electro-magnetic radiation, for measuring temperature and for generating a thermo-electric current, characterised in that the pyro-electric component consists of a monocrystal having a basis of rhombic lithium metagermanate ($Li_2GeO_3$).

2. A pyro-electric component as claimed in claim 1, characterised in that at least one lithium atom is wholly or partially replaced by a sodium atom, and/or at least one germanium atom is wholly or partially replaced by a silicon atom.

3. A pyro-electric component as claimed in claims 1 and 2, characterised in that the monocrystal is provided with electrodes for measuring the electric charges.

4. A pyro-electric component as claimed in claim 3, characterised in that the surface of the crystal which faces the incident rays is provided with a selective filter for specific spectral regions of the electro-magnetic radiation.

5. A pyro-electric component as claimed in claim 4, characterised in that the component is operated simultaneously with one or more further pyro-electric components, at least one or more of which is or are provided with a filter or filters, in order to be able to measure the spectral distribution of the intensity of electro-magnetic radiations from the difference in the signals.

6. The use of the pyro-electric component as claimed in claim 3 for measuring neutron, electron or $\alpha$ particule currents.

7. The use of the pyro-electric component as claimed in claim 5 for direct spectral analysis.

8. The use of the pyro-electric component as claimed in claim 3 for temperature measurement, preferably for temperatures higher than 49°C, wherein the temperature-dependent polarisation occuring at the component is determined by a charge-measuring device.

9. The use of a plurality of pyro-electric components as claimed in claim 3 for the production of thermo-electric generators for current generation, wherein metallized surfaces of the components of the same polarity are connected to one another.

## Revendications

1. Composant pyro-électrique destiné à la mesure de l'intensité d'un rayonnement électromagnétique, au repérage de la température ainsi qu'à l'obtention d'un courant thermo-électrique, caractérisé en ce que le composant pyro-électrique se compose d'un monocristal à base d'un métagermanate de lithium rhombique ($Li_2GeO_3$).

2. Composant pyro-électrique suivant la revendication 1, caractérisé en ce qu'au moins un atome de lithium est remplacé en tout ou partie par un atome de sodium et/ou au moins un atome de germanium est remplacé en tout ou partie par un atome de silicium.

3. Composant pyro-électrique suivant les revendications 1 et 2, caractérisé en ce que le monocristal est muni d'électrodes destinées à prélever des charges électriques.

4. Composant pyro-électrique suivant la revendication 3, caractérisé en ce que la face du cristal tournée vers le rayonnement incident est muni d'un filtre sélectif pour des régions spectrales déterminées du rayonnement électromagnétique.

5. Composant pyro-électrique suivant la revendication 4, caractérisé en ce qu'il est muni est mis en fonctionnement simultanément avec un ou avec plusieurs autres composants pyro-électrique(s), dont l'un ou plusieurs d'entre eux est ou sont muni(s) de filtres afin de pouvoir mesurer, à partir de la différence des signaux, la répartition spectrale de l'intensité des rayonnements électromagnétiques.

6. Utilisation du composant pyro-électrique suivant la revendication 3 pour la mesure de courant de neutrons, d'électrons ou de particules $\alpha$.

7. Utilisation du composant pyro-électrique suivant la revendication 5 pour effectuer des analyses spectrales directes.

8. Utilisation du composant pyro-électrique suivant la revendication 3 pour repérage de la température, de préférence pour des températures plus élevées que 49°C, la polarisation qui se crée dans le composant et qui dépend de la température étant déterminée à l'aide d'un appareil de mesure de charge.

9. Utilisation de plusieurs composants pyro-électriques suivant la revendication 3 pour la fabrication de générateurs thermo-électriques en vue de l'obtention d'un courant, les faces métallisées de même polarité des composants étant reliées les unes aux autres.